(19) Europäisches Patentamt
European Patent Office
Office européen des brevets

(11) Publication number: **0 249 365 A2**

# (12) EUROPEAN PATENT APPLICATION

(21) Application number: **87304762.5**

(51) Int. Cl.[4]: **C08F 2/50**

(22) Date of filing: **29.05.87**

(30) Priority: **04.06.86 US 870673**

(43) Date of publication of application:
**16.12.87 Bulletin 87/51**

(84) Designated Contracting States:
**DE FR GB SE**

(71) Applicant: **LOCTITE (IRELAND) Ltd.**
**Whitestown Industrial Estate**
**Tallaght, Co. Dublin 24(IE)**

(72) Inventor: **Woods, John**
**138, Stillorgan Wood Upper Kilmacud Road**
**Stillorgan County Dublin(IE)**
Inventor: **Rooney, John M.**
**64, Walter Street**
**South Glastonbury, CT 06073(US)**

(74) Representative: **Marchant, James Ian et al**
**Elkington and Fife High Holborn House 52/54**
**High Holborn**
**London WC1V 6SH(GB)**

(54) **Photocatalysts for vinyl compounds activated by an electron donating hetero atom.**

(57) Compositions of compounds having vinyl groups activated by electronically adjacent ether oxygen atoms, thioether sulfur atoms or tertiary amino atoms α-or β-sulfonyloxyacetophenone compounds which photodegrade to form sulfonic acids are photocurable by a cationic mechanism. Suitable examples of the vinyl compounds are vinyl ethers, p-stryloxy ethers and N-vinyl carbazole. Suitable examples of sulfonyloxyacetophenone compounds are the reaction products of α-or β-hydroxyacetophenone compounds and mono or plural sulfonyl chloride compounds.

EP 0 249 365 A2

# PHOTOCATALYSTS FOR VINYL COMPOUNDS ACTIVATED BY AN ELECTRON DONATING HETERO ATOM

## BACKGROUND OF THE INVENTION

Kirchmayer et al, U.S. 4,504,372 and 4,510,290, disclose compounds which degrade on irradiation to release sulfonic acids which in turn initiate cure of acid curable resins such as melamine resins, phenol-formaldehyde resins, methylol resins, etc, by acid catalyzed condensation reactions at elevated temperatures.

Compounds of the type disclosed in U.S. 4,504,372 and 4,510,290, however, have not been previously described as cationic photoinitiators. That is, they are not known to induce addition polymerization of cationically polymerizable monomers. In fact, it has now been discovered that these compounds do not catalyze polymerization of the most common class of cationically polymerizable compounds, the epoxies.

## SUMMARY OF THE INVENTION

Applicants have discovered that despite their inability to induce cationic polymerization of epoxy compounds, the photocatalyst compounds of U.S. 4,504,372 and 4,510,290 all surprisingly induce cationic polymerization of vinyl monomers which are activated for cationic polymerization by an electronically adjacent electron donating heteroatom. The present invention therefore comprises a photocurable composition comprising:

a) a compound characterized by the presence of at least one vinyl group activated by an electronically adjacent ether oxygen, thioether sulfur or tertiary aryl amine nitrogen atom; and

b) an α-or β-sulfonyloxyacetophenone compound of Formula I, II or III;

I 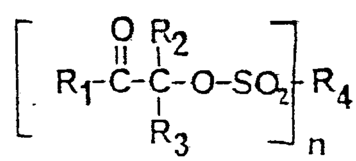

II 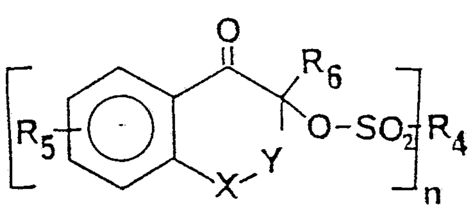

III 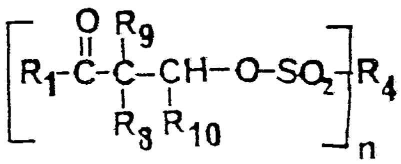

In which n is a positive integer; $R_1$ is aryl which is substituted or unsubstituted; $R_2$ is hydrogen, benzoyl or $C_1$-$C_8$-alkyl which is unsubstituted or substituted; $R_3$ is as defined for $R_2$ or phenyl which is unsubstituted or substituted, or $R_2$ and $R_3$, together with the carbon atom to which they are attached constitute a $C_4$-$C_6$-cycloalkyl ring; X is -O-, -S-, $-SO_2$, $-CH_2$, $-C(CH_3)_2$-or >N-$COR_7$, $R_7$ being $C_1$-$C_4$-alkyl or phenyl; Y is a direct

bond or $-CH_2$; $R_4$ is an n-valent hydrocarbyl group which is unsubstituted or substituted by halogen or which may have one or more oxygen atoms interrupting the carbon atoms thereof or $R_4$ is an organic or silicone polymer having n pendant or terminal hydrocarbylene groups; $R_5$ is H or 1, 2 or 3 radicals belonging to the group consisting of halo, benzoyl, hydrocarbyl, hydrocarbyloxy, cyano, nitro, hydrocarbylthio, hydroxyalkylenethio, hydrocarbylsulfonyl or hydrocarbylamide; $R_6$ is as defined for $R^3$; $R_8$ is hydrogen, -OH or alkyl, $R_9$ is hydrogen or alkyl, and $R_{10}$ is hydrogen, aryl, alkenyl, furyl, or $-CCl_3$.

Current photocatalysts for acid sensitive vinyl monomers are ionic and frequently their usefulness is limited due to incompatibility. The catalysts used in this invention are covalent and are readily compatible with a wide range of monomers.

## DETAILED DESCRIPTION OF THE INVENTION

The activated vinyl compounds useful in the inventive compositions are those which have an electronically adjacent ether oxygen atom, thioether sulfur atom or tertiaryaryl amine nitrogen atom. As used herein, the heteroatom is electronically adjacent if it can effectively donate its unshared electron pair to the double bond of the polymerizable vinyl group. Vinyl ether compounds in which the oxygen atom is directly bonded to one of the vinyl carbon atoms are one such class of activated vinyl compounds. The thioether analogues of vinyl ethers and N-vinyl substituted tertiary aryl amines, such as N-vinyl carbazole or N,N,N-diphenylvinylamine are further examples of vinyl monomers having a directly bonded heteroatom.

The vinyl ether compounds useful in the inventive compositions may be represented by the formulas:

$$(CH_2{=}CH{-}O{-}CH_2)_n{-}G$$

$$(CH_2{=}CH{-}O{-}C_6H_4)_n{-}G$$

$$(CH_2{=}CH{-}O{-}CR^{11}{=}CR^{12})_n{-}G$$

$$(CH_2{=}CH{-}O{-}C{\equiv}C)_n{-}G$$

or ketene acetals such as those of the formulas:

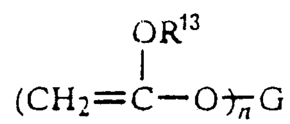

or

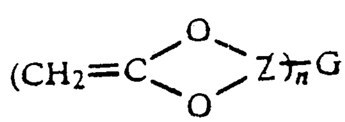

where G is a mono or multivalent radical which is free of groups which interfere with cationic polymerization and which, when attached directly to the oxygen atom of a oxyhydrocarbyl group, forms a ether with the oxyhydrocarbyl group to which it is attached; m is an integer equal to the valency of G; $R^{11}$ and $R^{12}$ are selected from H, alkyl, haloalkyl, or alkyl which is interrupted by one or more ether oxygen atoms, aryl which may be optionally substituted by halogen, alkyl or alkoxy; $R^{13}$ is selcted from alkyl or aryl either of which may be optionally substituted as in $R^{11}$ and $R^{12}$; and Z is a hydrocarbyl group of 1-5 carbon atoms. Suitable vinyl ether monomers are listed in U.S. 3,196,098 at Col. 3, lns 1-16, incorporated hereby by reference. Preferred vinyl ether compounds are those in which n is two or more such as those described in

U.S. 4,416,752 at column 4, lines 54-58. Compounds with furyl or pyranyl groups are also considered vinyl ether compounds useful in the inventive compositions.

The hetero atom need not be directly bonded to a carbon atom of the vinyl group, however. A heteroatom which can effectively donate its unshared electron pair to the vinyl group through a system of conjugated aromatic or olefinic hydrocarbon bonds. A prime example of such compounds are the p-styryloxy ether monomers.

Styryloxy ether monomers are compounds containing one or more groups of the formula:

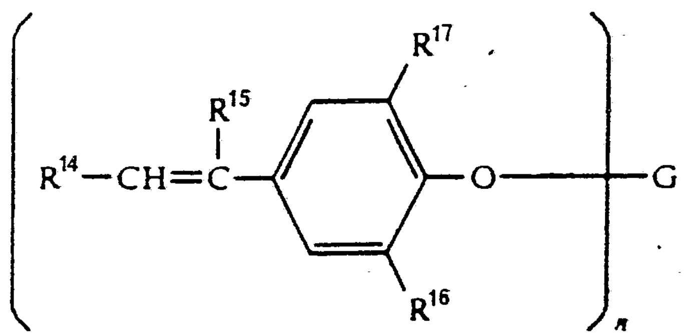

or of the formula:

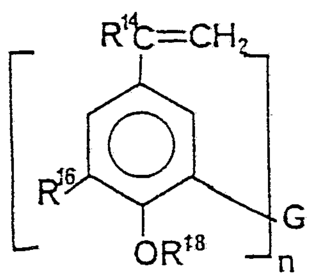

where $R^{14}$ and $R^{15}$ are H or methyl, provided that $R^{14}$ and $R^{15}$ are not both methyl, $R^{16}$ and $R^{17}$ are H, lower alkyl or alkoxy and $R^{18}$ is hydrocarbyl. hydrocarbyl interrupted by ether oxygen atoms or halohydrocarbyl. Preferably the compounds contain two or more groups or the above formulas. Such compounds are described in U.S. 4,543,397 and in co-pending U.S. applications 779,737, filed September 24, 1985, and 824,903, filed January 31, 1986, the disclosures of which are all incorporated herein by reference.

Likewise included in the category of vinyl compounds having electron donating heteroatoms electronically adjacent to the vinyl group are:

butadienyl ethers:

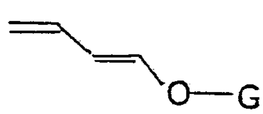

and their aromatic analogues:

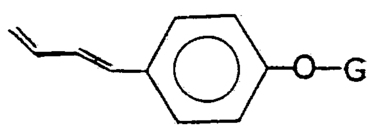

4-vinyl-1,1'bisphenyls having 2' or 4' alkoxy substituents such as disclosed in U.S. 4,412,050; and tertiary aryl amine resins in which the vinyl group is a substituent on the aromatic amines, such as 3-vinyl carbazole or p-vinyl-N,N-diethylaniline.

The thioether compounds useful in the inventive compositions are analogues of the foregoing ether compounds in which the ether oxygen atom is replaced by a thioether sulfur atom.

It should be noted that, as used herein, the term tertiary aryl amine is an amino compound in which the nitrogen atom is bound to single C-N bonds to one or more aryl groups. The term is not intended to include compounds such as pyridine in which a nitrogen atom is incorporated into an aromatic ring structure.

The activated vinyl compounds should be free of groups which interfere with cationic polymerizations. Amino groups not in conjugation with the activated vinyl, primary or secondary amino groups regardless of their location and thiol groups are particularly undesirable. Aliphatic hydroxyl groups are not recommended but can be tolerated in compositions employing compounds having plural activated vinyl groups as the hydroxyl group acts as a chain transfer agent rather than a quencher of chain propagation.

The $\alpha$-or $\beta$-sulfonyloxyacetophenone compounds used as the cationic photoinitiator in the inventive compositions are obtainable commercially or may be prepared by a skilled organic chemist by methods described in U.S. 4,510,290 or 4,504,372.

In Formula I, II and III, n is a positive integer, suitably 1 or 2 and $R_1$ is aryl which is unsubstituted or substituted by halo, benzoyl, hydrocarbyl, hydrocarbyloxy, cyano, nitro, hydrocarbylthio, hydroxyalkylenethio, hydrocarbylsulfonyl, hydrocarbylamido or heterocyclic groups in which the heteroatoms are selected from the group consisting of oxygen and sulfur atoms. For example, $R_1$ may be phenyl or napthyl substituted by 1, 2 or 3 radicals belonging to the group comprising -Cl, -Br, -CN, $-NO_2$, $C_1$-$C_{12}$-alkyl, $C_1$-$C_4$-alkoxy, phenoxy, tolyloxy, phenylthio, tolylthio, $C_1$-$C_8$-alkylthio, $-SCH_2CH_2OH$, $C_1$-$C_4$-alkylsulfonyl, phenylsulfonyl, $C_2$-$C_4$-alkoxycarbonyl, phenyl-CONH-, $C_1$-$C_4$-alkyl-CONH-or benzoyl. Or $R_1$ may also be anthryl, phenanthryl, thienyl, pyridyl, furyl, indolyl or tetrahydronaphthyl. $R_2$ is hydrogen, benzoyl, or $C_1$-$C_8$-alkyl which is unsubstituted or substituted for example, by -OH, -Cl, $C_1$-$C_4$-alkoxy, -CN, $C_2$-$C_5$-alkoxycarbonyl, phenyl, chlorophenyl, $C_7$-$C_{10}$-alkylphenyl or $C_7$-$C_{10}$-alkoxyphenyl. $R_3$ is as defined for $R_2$ or phenyl which is unsubstituted or substituted, for example, by -Cl, $C_1$-$C_4$-alkyl, $C_1$-$C_4$-alkoxy or $C_1$-$C_4$-alkylthio, $C_2$-$C_8$-alkoxycarbonyl, -CN, $C_1$-$C_4$-alkyl-NH-CO-, phenyl-NH-CO-or $-CONH_2$. Alternatively, $R_2$ and $R_3$, together with the carbon atom to which they are attached, constitute a $C_4$-$C_6$-cycloalkyl ring. X is -O-, -S-, $-SO_2$-, $-CH_2$-, $-C(CH_3)_2$-or >NOCOR$_7$, $R_7$ being $C_1$-$C_4$-alkyl or phenyl. Y is a direct bond or $-CH_2$-. $R_4$ is an n-valent hydrocarbyl group, such as $C_1$-$C_{18}$ alkyl or phenyl, which may be substituted with halogen atoms or which may have one or more ether oxygen atoms interrupting the carbon atoms thereof, or $R_4$ is an organic or silicone polymer having n pendant or terminal hydrocarbylene groups. Suitable $R_4$ groups when n is 1 are alkyl, cycloalkyl, aryl, aralkyl, alkaryl or camphoryl. Suitable $R_4$ groups when n is 2 are alkylene, phenylene, napthalene and alkyl substituted phenylene or napthalene. $R_5$ is H or 1, 2 or 3 radicals belonging to the group comprising halo, benzoyl, hydrocarbyl, hydrocarbyloxy, cyano, nitro, hydrocarbylthio, hydroxyalkylenethio, hydrocarbylsulfonyl or hydrocarbylamido. $R_6$ is as defined for $R_3$.

$R_8$ is hydrogen, -OH or alkyl, $R_9$ is hydrogen or alkyl, $R_{10}$ is hydrogen, aryl, alkenyl, furyl or $-CCl_3$.

$C_1$-$C_{12}$-alkyl substituents in phenyl or naphthyl, as $R_1$, are linear or branched substituents, for example methyl, ethyl, n-propyl, isopropyl, n-butyl, sec.-butyl, tert-butyl, pentyl, hexyl, heptyl, octyl, nonyl, decyl, undecyl or dodecyl, but particularly methyl. $C_1$-$C_4$-alkoxy substituents in phenyl or naphthyl, as $R_1$, are, for example, methoxy, ethoxy, propoxy or tert.-butoxy.

$C_1$-$C_8$-alkylthio substituents in phenyl or naphthyl, as $R_1$, and in $R_5$ are linear or branched substituents, for example methylthio, ethylthio, n-propylthio, isopropylthio, n-butylthio, sec.-butylthio, tert-butylthio, pentylthio, hexylthio, heptylthio or octylthio, but particularly methylthio.

A $C_1$-$C_4$-alkylsulfonyl substituent in phenyl or naphthyl, as $R_1$, is, for example, methylsulfonyl, ethylsulfonyl, propylsulfonyl, butylsulfonyl or tert.-butylsulfonyl.

A $C_1$-$C_4$-alkyl-CONH-substituent in phenyl or naphthyl, as $R_1$, is, for example, methyl-CONH-, ethyl-CONH-, propyl-CONH-or n-butyl-CONH-, $C_1$-$C_4$-alkyl-NHCO-present in $R_2$ or $R_3$, and $C_1$-$C_4$-alkyl-CONH-present in $R_4$ are, for example, respectively, methyl-NHCO-ethyl-NHCO-, propyl-NHCO-or n-butyl-NHCO-substituents or methyl-CONH-, ethyl-CONH-, propyl-CONH-or n-butyl-CONH-substituents.

All the position isomers of thienyl, pyridyl, furyl, indolyl or tetrahydronaphthyl, as $R_1$, are suitable. However, preferred position isomers are 2-thienyl, 3-pyridyl, 2-furyl, 3-indolyl or 1,2,3,4-tetrahydro-6-naphthyl.

As $C_1$-$C_8$-alkyl, $R_2$, $R_3$ and $R_6$ are linear or branched alkyl groups, but preferably linear $C_1$-$C_4$-alkyl groups, for example methyl, ethyl, n-propyl or n-butyl.

$C_1$-$C_4$-alkoxy substituents in $C_1$-$C_8$-alkyl, as $R_2$, $R_3$ and $R_6$, or in phenyl or naphthyl, as $R_4$ or $R_5$, are, for example, methoxy, ethoxy, propoxy or tert.-butoxy substituents.

$C_7$-$C_{10}$-alkylphenyl or $C_7$-$C_{10}$-alkoxyphenyl substituents in $C_1$-$C_8$-alkyl, as $R_2$, $R_3$ and $R_6$, are, for example, methylphenyl, methoxyphenyl, ethylphenyl, ethoxyphenyl, tert.-butylphenyl or tert.-butoxy-phenyl.

$C_1$-$C_4$-alkylthio substituents in phenyl, as $R_3$ and $R_6$, are, for example, methylthio, ethylthio, propylthio or tert.-butylthio.

A cycloalkyl ring which is formed by $R_2$ and $R_3$, together with the C atom to which they are attached, is, for example, a cyclopentane, cyclohexane or cycloheptane ring, but particularly a cyclohexane ring.

$R_4$ may be a linear or branched $C_1$-$C_{18}$-alkyl group, for example methyl, ethyl, propyl, isopropyl, butyl, tert.-butyl, pentyl, hexyl, heptyl, octyl, nonyl, decyl, 2-ethylhexyl, undecyl, dodecyl, tert.-dodecyl, tridecyl, tetradecyl, hexadecyl or octadecyl.

$C_1$-$C_{12}$-alkyl substituents in phenyl or naphthyl, as $R_4$ and in $R_5$ are linear or branched alkyl groups.

$C_5$-$C_6$-cycloalkyl which is represented by $R_4$ are cyclopentyl and cyclohexyl.

$C_7$-$C_9$-aralkyl which is represented by $R_4$ is, for example, 1-phenylethyl, 2-phenylethyl or benzyl.

Camphoryl as $R_4$ is 10-camphoryl.

If n = 2: a $-(CH_2)m$-group which is represented by $R_4$ is, for example, ethylene, propylene, butylene, pentylene or hexamethylene.

$C_1$-$C_{12}$-alkyl substituents in phenylene or naphthylene are linear or branched alkyl groups.

If the various phenyl groups in the radicals $R_1$, $R_3$, $R_4$ and $R_6$ are substituted by radicals other than hydrogen atoms, this substitution takes place in the ortho-, meta-or para-position, but particularly in the para-position.

Preferred curing catalysts are those of the formula I wherein n is the number 1 or 2, $R_1$ is phenyl or naphthyl which is unsubstituted or is substituted, for example, by -Cl, -Br, $C_1$-$C_8$-alkyl, $C_1$-$C_4$-alkoxy, phenoxy, tolyloxy, phenylthio, tolylthio, $-SCH_2CH_2OH$, $C_1$-$C_8$-alkylthio or benzoyl, or is anthryl or phenanthryl, $R_2$ is hydrogen or $C_1$-$C_8$-alkyl which is unsubstituted or is substituted, for example, by -OH, -Cl, -CN, $C_2$-$C_5$-alkoxycarbonyl, phenyl, chlorophenyl, $C_7$-$C_{10}$-alkylphenyl or $C_7$-$C_{10}$-alkoxyphenyl and $R_3$ is the same as $R_2$, as defined above, and is also phenyl which is unsubstituted or is substituted, for example, by -Cl, $C_1$-$C_4$-alkyl, $C_1$-$C_4$-alkoxy or $C_1$-$C_4$-alkylthio, or is $C_2$-$C_4$-alkoxycarbonyl or -CN, or $R_2$ and $R_3$, together with the carbon atom to which they are attached, form a $C_4$-$C_6$-cycloalkyl ring and, if n = 1, $R_4$ is $C_1$-$C_{18}$-alkyl, phenyl which is unsubstituted or is substituted, for example, by -Cl, $C_1$-$C_{12}$-alkyl, or $C_1$-$C_4$-alkoxy, or is naphthyl which is unsubstituted or is substituted, for example, by -Cl or $C_1$-$C_{12}$-alkyl, or $R_4$ is also camphoryl, $-CF_3$ or -F, and, if n = 2, $R_4$ is a $-(CH_2)-_m$ group, phenylene or naphthylene, m being the number 2, 3 or 4.

Sulfonyloxyacetophenone compounds which are very particularly preferred are those of the formula I in which n = 1, $R_1$ is phenyl, p-tolyl or p-methylthiophenyl, $R_2$ is hydrogen, $R_3$ is phenyl, methyl, isopropyl, n-decyl or benzyl and $R_4$ is phenyl, p-tolyl or p-n-dodecylphenyl.

Sulfonyloxyacetophenone compounds which are also particularly preferred are those of the formula II in which n = 1, $R_5$ and $R_6$ are hydrogen, X and Y are a $-CH_2$-group and $R_4$ is $C_1$-$C_{18}$-alkyl, phenyl or naphthyl which is unsubstituted or is substituted , for example, by $C_1$-$C_{12}$-alkyl, or is camphoryl.

The following are examples of individual compounds of the formula I: 2-[(p-tolylsulfonyl)-oxy]-1-phenyl-1-propanone, 2-[(p-tolylsulfonyl)-oxy]-1-p-tolyl-1-propanone, 2-[(p-chlorophenylsulfonyl)-oxy]-1-phenyl-1-propanone, 2-[(p-laurylphenylsulfonyl)-oxy]-1-phenyl-1-propanone, 2-[(p-methoxyphenylsulfonyl)-oxy]-1-phenyl-1-propanone, 2-[(p-methylthiophenylsulfonyl)-oxy]-1-phenyl-1-propanone, 2-[(p-acetamidophenylsulfonyl)-oxy]-1-phenyl-1-propanone, 2-[(methylsulfonyl)-oxy]-1-phenyl-1-propanone, benzoin toluenesulfonate, benzoin methanesulfonate, benzoin p-dodecylbenzenesulfonate, 4,4′-bis-methylthiobenzoin toluenesulfonate, 2-[(o-nitrophenylsulfonyl)-oxy]-1-phenyl-1-propanone, 2-[(benzylsulfonyl)-oxy]-1-phenyl-1-propanone, 2-[(n-octylsulfonyl)-oxy]-1-phenyl-1-propanone, 2-[(cyclohexylsulfonyl)-oxy]-1-phenyl-1-propanone, 2-[-(phenylsulfonyl)-oxy]-1-phenyl-1-propanone, 2-[(naphthylsulfonyl)-oxy]-1-phenyl-1-propanone, 2-[-(trifluoromethylsulfonyl)-oxy]-1-phenyl-1-propanone, 2-[(chloroethylsulfonyl)-oxy]-1-phenyl-1-propanone, 2-[-(mesitylsulfonyl)-oxy]-1-phenyl-1-propanone, 2-[(10-camphorylsulfonyl)-oxy]-1-phenyl-1-propanone, 1-benzoyl-1-methylsulfonyloxy-cyclohexane, 2-[(p-tolylsulfonyl)-oxy]-1-(2′-thienyl)-1-propanone, 2-[-(methylsulfonyl)-oxy]-1-(6′-tetralin)-1-propanone, 2-[(p-tolylsulfonyl)-oxy]-1-phenyl-1-octanone, 2-[(p-tolylsulfonyl)-oxy]-1-phenyl-1-dodecanone, 2-[(p-tolylsulfonyl)-oxy]-1-p-tolyl-1-dodecanone, 2-[(methylsulfonyl)-oxy]-4-ethoxycarbonyl-1-phenyl-1-butanone, 2-[(p-tolylsulfonyl)-oxy]-acetophenone, 2-[(p-tolylsulfonyl)-oxy]-2-methyl-1-phenyl-1-propanone, 2-[(10′-camphorylsulfonyl)-oxy]-acetophenone, 2-[(10′-camphorylsulfonyl)-oxy]-2-methyl-1-(p-methyl)-phenyl-1-propanone, 2-[(10′-camphorylsulfonyl)-oxy]-2-methyl-1-(p-methylthio)-phenyl-1-propanone, 2-[(10′-camphorylsulfonyl)-oxy]-1-p-(-hydroxyethylthio) -phenyl-1-propanone, 2-[(10′-camphorylsulfonyl)-oxy]-1-(p-chloro)-phenyl-1-propanone, 2-[(p-tolylsulfonyl)-oxy]-1,3-bis-phenyl-1-propanone, 2-[(methylsulfonyl)-oxy]-1,3-bis-phenyl-1-propanone, 2-[(p-tolylsulfonyl)-oxy]-3-phenyl-1-p-tolyl-1-propanone, 2-[(p-laurylphenylsulfonyl)-oxy]-1,3-bis-phenyl-1-propanone, 2-[(p-tolylsulfonyl)-oxy]-2-methoxymethyl-1-phenyl-1-propanone, 2-[(methyl sulfonyl)-oxy]-2-chloromethyl-1-phenyl-1-propanone, 2-[-(p-tolylsulfonyl)-oxy]-p-methylthioacetophenone, 2-[(methylsulfonyl)-oxy]-1-(p-methylthio)-phenyl-1-propanone, 2-[(p-tolylsulfonyl)-oxy]-1-(p-methylthio)-phenyl-1-propanone, 2-[(p-laurylphenylsulfonyl)-oxy]-1-(p-methylthio)phenyl-1-propanone, 2-[(p-tolylsulfonyl)-oxy]-3-phenyl-1-(p-methylthio)-phenyl-1-propanone, 2-[-(p-tolylsulfonyl)-oxy]-1-(p-phenylthio)-phenyl-1-propanone, 2-[(p-tolylsulfonyl)-oxy]-1-(p-acetamido)-phenyl-1-propanone, 2-[(p-lauryl-phenylsulfonyl)-oxy]-3-methyl-1-p-methylthiophenyl-1-butanone, 2-[(p-tolylsulfonyl)-oxy]-3-methyl-1-phenyl-1-butanone, 2-[(p-tolylsulfonyl)-oxy]-3-methyl-1-p-tolyl-1-butanone, 2-[(p-tolylsulfonyl)-oxy]-1-naphthyl-1-propanone, 2-[(p-tolylsulfonyl)-oxy]-2-ethoxycarbonylacetophenone, diethyl 3-[(p-tolylsulfonyl)-oxy]-3-benzoylmalonate, (1′-benzoyl)-ethyl phthalic-anhydride-5-sulfonate, (1′-methyl-1′-benzoyl)-ethyl N-methylphthalimide-5-sulfonate, bis-(1′-benzoyl)-ethyl naphthalene-2,6-disulfonate and bis-(1′-benzoyl-1′-methyl)-ethyl dinonylnaphthalenedisulfonate.

The following are examples of individual compounds of the formula II: 2-[(methylsulfonyl)-oxy]-2-methyltetral-1-one, 2-[(methylsulfonyl)-oxy]-tetral-1-one, 2-[(p-tolylsulfonyl)-oxy]-tetral-1-one, 2-[(p-laurylphenylsulfonyl)-oxy]tetral-1-one, 3-[(p-tolylsulfonyl)-oxy]-chromone, 3-[(p-tolylsulfonyl)-oxy]-1-thiochroman-4-one, 3-[(camphorylsulfonyl)-oxy]-1-thiochroman-4-one-S-dioxide, 2-[(methylsulfonyl)-oxy]-coumaran-3-one and 2-[(phenylsulfonyl)-oxy]-indan-1-one.

The compounds of the formulae I-III are known and can be prepared by known processes, for example by reacting the corresponding hydroxy compounds of the formulae IV (a-c):

IV (a) 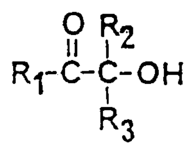

(b) 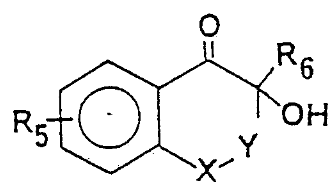

(c) 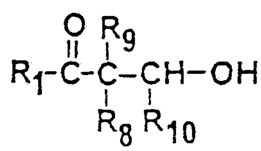

with an equivalent amount of the corresponding monosulfonyl, disulfonyl or polysulfonyl chlorides, respectively, of the formula V

$R_4(SO_2Cl)n$ V

in the presence of a base [in this connection see Journal of the Chemical Society, Perkin I, 1981, page 263 or Journal of Org. Chem. 34, 1,595 (1969)]. Examples of polysulfonyl chlorides include chlorosulfonated polyethylene and chlorosulfonated polystyrene.

Further synthetic methods for the compounds of Formulae I, II and III are disclosed in U.S. 4,504,372 and 4,510,290.

The sulfonyloxoacetophenone compounds according to the invention are added to the activated vinyl compounds in an amount which is adequate for curing. In general, an adequate amount for curing is 0.01 to 10% by weight, preferably 0.1 to 5% by weight, still more preferably 0.5-3% by weight, based on the vinyl compound. It is also possible to employ mixtures of the curing catalysts according to the invention.

The invention is further illustrated by reference to the following Examples.

The examples which follow illustrate the process in greater detail by reference to specific compositions according to the invention. In these examples, parts are parts by weight and % are percentages by weight.

## EXAMPLE 1

A solution of 1.10g p-toluenesulfonic acid in 6.0 mls of tetrahydrofuran (THF) was added to a stirred solution of (0.85 g) α-diazoacetophenone (prepared by reacting benzoyl chloride and diazomethane according to the procedure of Charlton et al described in Can. J. Chem, 58, 458, 1980). After 3 hours, a thin layer chromatogram of the reaction mixture indicated that a single product had formed and that both

starting materials had been consumed. The solvent (THF) was removed under reduced pressure and the residue dissolved in 25 mls of dichloromethane. The dichloromethane solution was washed with 2 x 20 ml portions of saturated sodium bicarbonate solution followed by 2 x 20 ml portions of water and dried over $Na_2SO_4$. The solvent was removed to yield 1.44 g of pure α-tosyloxyacetophenone with the formula:

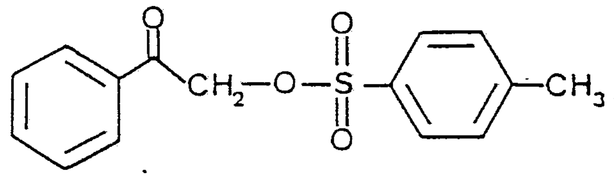

EXAMPLE 2

A solution of 19.5 g of a tetra functional polymethylhydrosiloxane (PS 118 from Petrarch Systems, Inc.) in 20 mls of toluene was added gradually to a stirred solution of 33.6 g of 4-allyloxystyrene (prepared as described in U.S. Patent 4,543,397) in 50 mls of toluene, containing 0.7 g of a 2% solution of dihydrogen hexachloroplatinate hexahydrate in n-butylacetate, at 80°C. At the end of the addition, an infrared spectrum of the mixture showed that the peak at 2,130 $cm^{-1}$ had almost disappeared indicating nearly complete consumption of the Si-H groups. The solvent was removed and 52.8 g of a pale yellow liquid was obtained with molecular weights in the range 900-1100. The principal component may be regarded as having the chemical formula:

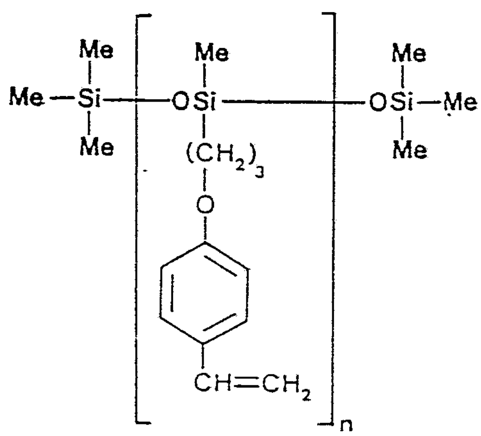

$n \cong 4$

EXAMPLE 3

A UV light sensitive composition was prepared by dissolving 0.3 g of photocatalyst α-tosyloxyacetophenone (prepared as described in Example 1) in 9.7 g of the styryloxy silicone resin of Example 2. The composition was poured into a 1mm deep, 10mm diameter plastic cup and exposed to UV light 1cm from the tip of a light guide of a LUMATEC SUPERLITE UV 201 for 3 min. After this time, the liquid resin composition had gelled to a solvent insoluble material. The liquid resin, without added photocatalyst showed no change when irradiated under similar conditions.

EXAMPLE 4

A solution of 21.2g of benzoin and 430g toluene was prepared by heating the mixture to 70°C. 19.5g of p-toluenesulfonyl chloride was then added and the mixture cooled to 30°C. 6.33g of powdered sodium hydroxide was then added and the mixture stirred for 2.5 hours. After a further 16 hours, the mixture was washed with 3 x 150 ml portions of water and the organic fraction dried over sodium sulfate. The desiccant

was removed by filtration and the toluene solution concentrated by removal of part of the solvent under reduced pressure. The mixture was cooled to -18°C. After 16 hours, 9.53g of a crystalline precipitate had formed which was removed by filtration and dried. This material was found to be unreacted benzoin. The filtrate was further concentrated and again cooled to -18°C. After 1 hour, a second crop of crystals had formed. These crystals were collected by filtration and dried to give 7.64g of crude product. This was recrystallized from industrial methylated spirit to yield 4.64g of pure α-tosyloxy-α-phenylacetophenone. The structure was confirmed by NMR and IR spectroscopy and by gel permeation chromatography (GPC):

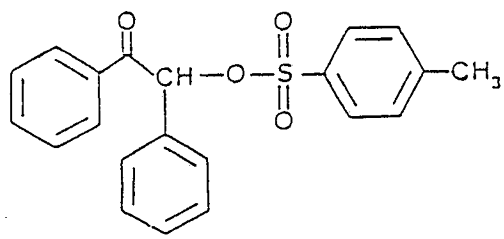

60MH$_z$, Proton NMR ($CDCl_3$): $\tau = 2.2$-$3.0$, multiplet, 14H, aromatic protons; $\tau = 3.4$, singlet, 1H, methine proton; $\tau = 7.75$, singlet 3H, methyl group.

I.R. (film cast on KBr disc from $CDCl_3$) : 3020 $cm^{-1}$, (W), AR-H; 1690 $cm^{-1}$, (S), aromatic carbonyl group, 1590 $cm^{-1}$, (m), AR-H ; 1320 and 1140 $cm^{-1}$. (S), $-SO_2$-O-group.

GPC analysis (microstyrogel columns) indicated only one component, higher in molecular weight than either starting material.

EXAMPLE 5

A UV sensitive composition was prepared by dissolving 0.3 g of α-tosyloxy-α-phenylacetophenone (Example 4) in 9.7 g of butane diol divinyl ether. After 100 seconds irradiation, by the method described in Example 3, a black, solvent insoluble material had formed. Irradiation of the divinyl ether without added photocatalyst showed no change after irradiation under the same conditions.

EXAMPLE 6

A UV sensitive composition was prepared by dissolving 0.3 g of α-tosyloxy-α-phenylacetophenone (Example 4) in 9.7 g of styryloxy resin of Example 2. After 2 minutes irradiation, by the method described in Example 3, a gelled solvent insoluble material had formed.

EXAMPLE 7

To a solution of 1.07 g of 4-allyloxystyrene (synthesized according to procedure described in U.S. Patent 4,543,397) in 50 g toluene was added 0.67 g of a 2% solution of dihydrogen hexachloroplatinate hexahydrate in n-butylacetate and 0.25 g of 2,6-di-tert-butyl-4-methylphenol. The resulting solution was then heated to 80°C and 50 g of a difunctional Si-H terminated polydimethylsiloxane resin of molecular weight 15,000 was added gradually over 1 hour. At the end of this time, infrared spectroscopy showed that the peak at 2130 $cm^{-1}$ had disappeared indicating complete consumption of the Si-H group. Solvent was then removed under reduced pressure to yield 49.1 g of a resin which formed a purple gel on the addition of one drop of methane sulfonic acid.

EXAMPLE 8

A UV sensitive composition was prepared by blending 0.3 g of photocatalyst α-tosyloxy-α-phenylacetophenone (synthesized as in Example 4) with 9.7 g of styryloxy resin of Example 7. After 5 minutes irradiation, under the UV conditions described in Example 3, a gelled, solvent insoluble, material had formed. No curing was observed when the styryloxy resin without added catalyst was irradiated under the same conditions.

EXAMPLE 9

A stirred mixture of 130 g of 80% sodium dodecylbenzenesulfonate and 36 g of phosphorus oxychloride were heated at 170-180°C for 12 hours. The mixture was cooled and 500 mls of acetone added. The mixture was stirred and filtered. The solvent was removed from the filtrate and yielded 76.1 g of a black resin which was shown by GPC analysis to consist of only one major component. The material is believed to be crude p-dodecylbenzenesulfonyl chloride.

A 51.7 g sample of this resin was dissolved in 100 mls toluene and added dropwise to a stirred solution of 31.8 g benzoin and 30.3 g triethylamine in 150 mls toluene at 30°C. After the addition, the mixture was stirred for a further 18 hours at room temperature. The reaction mixture was filtered, and the filtrate washed with 2 x 150 ml portions of a solution prepared from equal volumes of water and saturated sodium chloride. The solvent was removed under reduced pressure to yield 65.2 g of a black viscous resin. GPC analysis indicated that the mixture comprised 4 major fractions. A 0.75 g aliquot was resolved using preparative, centrifugally accelerated, radial, thin layer chromatography (Chromatotron 7924T from T. C. Research). Eluting with 10% ether in hexane afforded 4 components the 3rd of which was identified by N.M.R. and I.R. spectroscopy to be pure α-dodecylbenzenesulfonyloxy-α-phenylacetophenone (yield 0.22 g):

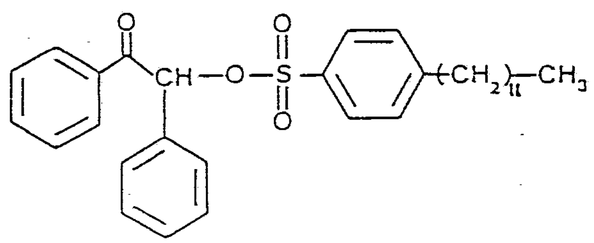

60 $MH_z$ proton NMR: $\tau$=2.1 - 2.9, multiplet, 14H, aromatic protons: $\tau$= 3.3, singlet, lH, methine proton, $\tau$=8.1 - 9.4 multiplet, 25H, alkyl protons. I.R. (KBr disc): 3040 $cm^{-1}$, (W) AR-H; 2910 $cm^{-1}$, (S), methylene and methyl groups; 1690 $cm^{-1}$, (S), aromatic carbonyl group; 1590 $cm^{-1}$, (M), AR-H; 1320 $cm^{-1}$, (S) and 1140 $cm^{-1}$, (S), $-SO_2$-O-group.

EXAMPLE 10

A UV sensitive composition was prepared by dissolving 0.03 g of photocatalyst α-dodecylbenzenesulfonyloxy-α-phenylacetophenone (Example 9) in 0.97 g of 1,4-butane diol divinyl ether. The composition was poured into 1mm deep, 10mm diameter plastic cup and irradiated for 60 seconds under a UVALOC 1000W (Loctite Deutschland Trade Mark) medium pressure mercury arc lamp operating at 200 W/in. The sample was located 30 cm directly under the arc. The UV intensity was meausred to be 50 $mW/cm^2$ (365 nm) at this point. After the UV exposure, the material was found to be insoluble in dichloromethane. Irradiation of the divinyl ether without added catalyst leaves the material unchanged.

EXAMPLE 11

A UV sensitive composition was prepared by dissolving 0.03g photocatalyst α-dodecylbenzenesulfonyloxy-α-phenylacetophenone (Example 9) in 0.97 g styryloxy resin of Example 2. The composition was exposed to UV light as described in Example 10. After 120 seconds irradiation, a solvent insoluble material had formed.

EXAMPLE 12

A UV sensitive composition was prepared by dissolving 1.00 g of N-vinylcarbazole and 0.02 g of photocatalyst α-tosyloxy-α-phenylacetophenone (Example 4) in 1.00 g of anisole. The solution was poured onto a glass slide to give an approximately 0.25 mm thick coating. The coated slide was located 10 cm directly under the UV source of the lamp described in Example 10 and exposed for 1 second. After this irradiation period, the liquid coating had been converted to a dark blue polymeric material which was insoluble in acetone. A similar composition without added photocatalyst remained unchanged after UV irradiation under the same conditions.

EXAMPLE 13 (Comparative Example)

A composition was prepared by dissolving 0.3 grams of α-tosyloxy-α-phenylacetophenone (Example 4) in 9.7 grams of 3,4-epoxycyclohexylmethyl-3,4-epoxycyclohexane carboxylate (supplied by Union Carbide under Trade Name ERL-4221). The composition was exposed to UV light, under the conditions described in Example 3, for 6 minutes. After this time, the liquid composition appeared to be unchanged and no gelation was observed.

**Claims**

1. A photocureable composition comprising:

a) a compound characterized by the presence of at least one vinyl group activated by an electronically adjacent ether oxygen, thioether sulfur or tertiary aryl amine nitrogen atom; and

b) an α-or β-sulfonyloxyacetophenone compound of Formula I, II or III;

I 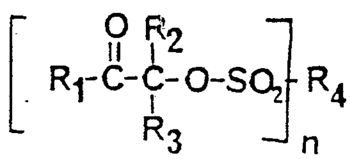

II 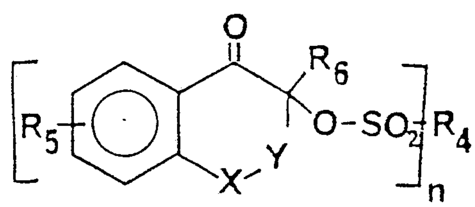

III 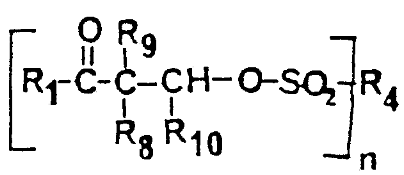

In which n is a positive integer; $R_1$ is aryl which is substituted or unsubstituted; $R_2$ is hydrogen, benzoyl or $C_1$-$C_8$-alkyl which is unsubstituted or substituted; $R_3$ is as defined for $R_2$ or phenyl which is unsubstituted or substituted, or $R_2$ and $R_3$, together with the carbon atom to which they are attached constitute a $C_4$-$C_6$-cycloalkyl ring; X is -O-, -S-, $-SO_2$, $-CH_2$, $-C(CH_3)_2$-or >B-$COR_7$, $R_7$ being $C_1$-$C_4$-alkyl or phenyl; Y is a direct

bond or $-CH_2$; $R_4$ is an n-valent hydrocarbyl group which is unsubstituted or substituted by halogen or which may have one or more oxygen atoms interrupting the carbon atoms thereof or $R_4$ is an organic or silicone polymer having n pendant or terminal hydrocarbylene groups; $R_5$ is H or 1, 2 or 3 radicals belonging to the group consisting of halo, benzoyl, hydrocarbyl, hydrocarbyloxy, cyano, nitro, hydrocarbylthio, hydroxyalkylenethio, hydrocarbylsulfonyl or hydrocarbylamide; $R_6$ is as defined for $R_3$; $R_8$ is hydrogen, -OH or alkyl, $R_9$ is hydrogen or alkyl, and $R_{10}$ is hydrogen, aryl, alkenyl, furyl, or $-CCl_3$.

2. A composition as in Claim 1 wherein the compound containing the activated vinyl group is an ether or thioether compound selected from:

a) Vinyl ethers;
b) p-styryloxy ethers;
c) 1,3-butadienyl ethers;
d) 4-(1,3-butadienyl)phenyl ethers;
e) 4-vinyl-1,1′ biphenyls having 2′ or 4′ alkoxy substituents; and
f) thioether analogues of compounds (a-e).

3) A composition as in Claim 1 wherein the compound containing vinyl group is activated by an electronically adjacent tertiary nitrogen atom.

4) A composition as in Claim 3 where the compound containing the activated vinyl group is N-vinyl carbazole, or 3-vinyl carbazole.

5) A composition as in Claim 2 wherein the compound containing the vinyl group is a vinyl ether.

6) A composition as in Claim 2 wherein the compound containing the vinyl group is a p-styryloxy ether.